# EUROPEAN PATENT APPLICATION

(11) **EP 4 333 157 A1**
(43) Date of publication of application: **06.03.2024**
(21) Application number: 23191121.5
(22) Date of filing: 11.08.2023
(51) Int. Cl.: H01M 10/42, H01M 50/209, H01M 50/284, H01M 50/519

(54) **BATTERY MODULE**

(30) Priority: 05.09.2022 JP 2022140759
(71) Applicant: Prime Planet Energy & Solutions, Inc., Chuo-ku Tokyo 103-0022 (JP)
(72) Inventor: INAMURA, Takashi, Tokyo, 103-0022 (JP)
(74) Representative: Kuhnen & Wacker Patent- und Rechtsanwaltsbüro PartG mbB

(57) **Abstract**

A battery module includes: a plurality of battery cells (100) arranged in a first direction; a plate member (400) provided on a first side of the plurality of battery cells (100); and a flexible printed board (500) and a control board (900) each provided on the plate member (400), wherein the flexible printed board (500) has a wiring (500B) electrically connected to the control board (900), and at least a portion of the wiring (500B) of the flexible printed board (500) is located between the control board (900) and at least one of the battery cells (100) at a region overlapping with the control board (900) when viewed from the first side.

## Description

### CROSS REFERENCE TO RELATED APPLICATIONS

This nonprovisional application is based on Japanese Patent Application No. 2022-140759 filed on September 5, 2022 with the Japan Patent Office, the entire contents of which are hereby incorporated by reference.

### BACKGROUND OF THE INVENTION

### Field of the Invention

The present technology relates to a battery module.

### Description of the Background Art

A flexible printed board may be used as a wiring of a battery module including a plurality of battery cells.

Technologies described in WO 2015/107583 and Japanese Patent Laying-Open No. 2019-114464 are exemplified as background technologies.

### SUMMARY OF THE INVENTION

As capacity of a battery pack is increased, the number of battery cells per battery module tends to be increased. This leads to an increased number of wirings to be disposed on the battery module. In order to handle this, it is required to efficiently utilize a limited space on the battery module.

It is an object of the present technology to provide a battery module on which a large number of wirings can be disposed by efficiently utilizing a limited space.

The present technology provides the following battery module.
[1] A battery module comprising: a plurality of battery cells arranged in a first direction; a plate member provided on a first side of the plurality of battery cells; and a flexible printed board and a control board each provided on the plate member, wherein the flexible printed board has a wiring electrically connected to the control board, and at least a portion of the wiring of the flexible printed board is located between the control board and at least one of the battery cells at a region overlapping with the control board when viewed from the first side.
[2] The battery module according to [1], wherein at least the portion of the wiring of the flexible printed board is located between the control board and the plate member at the region overlapping with the control board when viewed from the first side.
[3] The battery module according to [1] or [2], wherein the plate member has a protruding portion that positions the flexible printed board.
[4] The battery module according to any one of [1] to [3], wherein the control board has a connector portion, and the flexible printed board has a connection portion, and the flexible printed board and the control board are electrically connected to each other when the connection portion is connected to the connector portion.
[5] The battery module according to [4], wherein at least a portion of the connector portion or the connection portion is located between the control board and the at least one of the battery cells at the region overlapping with the control board when viewed from the first side.
[6] The battery module according to any one of [1] to [5], wherein the flexible printed board has a film layer and a conductor portion formed on the film layer and forming the wiring.
[7] The battery module according to any one of [1] to [6], wherein the wiring includes: a first portion that is located at the region overlapping with the control board when viewed from the first side; a second portion that is contiguous to the first portion and that is located at a region exposed from the control board when viewed from the first side; and a third portion that is contiguous to the second portion on a side opposite to the first portion and that is located at the region overlapping with the control board when viewed from the first side.
[8] The battery module according to any one of [1] to [7], wherein the wiring includes one of a voltage detection line or a temperature detection line.
[9] The battery module according to any one of [1] to [8], wherein the control board has a fastening portion with which the flexible printed board is fastened.
[10] The battery module according to [9], wherein the flexible printed board has an avoidance portion that avoids the fastening portion.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram showing a basic configuration of a battery module.
Fig. 2 is a perspective view showing a battery cell.
Fig. 3 is a perspective view showing a state in which a wiring module is provided on the battery module.
Fig. 4 is a diagram showing an arrangement of bus bars in a battery assembly.
Fig. 5 is a top view of the battery module.
Fig. 6 is a perspective view showing a flexible printed board and a control board shown in Fig. 5.
Fig. 7 is a diagram showing an exemplary positional relation between a connection portion of the flexible printed board and a connector portion of the control board.
Fig. 8 is a diagram showing a modification of the positional relation between the connection portion of the flexible printed board and the connector portion of the control board.
Fig. 9 is a top view showing a shape of a flexible printed board according to a modification.
Fig. 10 is a top view showing a shape of a flexible printed board according to another modification.

### DESCRIPTION OF THE PREFERRED EMBODIMENTS

Hereinafter, embodiments of the present technology will be described. It should be noted that the same or corresponding portions are denoted by the same reference characters, and may not be described repeatedly.

It should be noted that in the embodiments described below, when reference is made to number, amount, and the like, the scope of the present technology is not necessarily limited to the number, amount, and the like unless otherwise stated particularly. Further, in the embodiments described below, each component is not necessarily essential to the present technology unless otherwise stated particularly. Further, the present technology is not limited to one that necessarily exhibits all the functions and effects stated in the present embodiment.

It should be noted that in the present specification, the terms "comprise", "include", and "have" are open-end terms. That is, when a certain configuration is included, a configuration other than the foregoing configuration may or may not be included.

Also, in the present specification, when geometric terms and terms representing positional/directional relations are used, for example, when terms such as "parallel", "orthogonal", "obliquely at 45°", "coaxial", and "along" are used, these terms permit manufacturing errors or slight fluctuations. In the present specification, when terms representing relative positional relations such as "upper side" and "lower side" are used, each of these terms is used to indicate a relative positional relation in one state, and the relative positional relation may be reversed or turned at any angle in accordance with an installation direction of each mechanism (for example, the entire mechanism is reversed upside down).

In the present specification, the term "battery" is not limited to a lithium ion battery, and may include other batteries such as a nickel-metal hydride battery and a sodium ion battery. In the present specification, the term "electrode" may collectively represent a positive electrode and a negative electrode. Further, the term "electrode plate" may collectively represent a positive electrode plate and a negative electrode plate.

In the present specification, the "battery cell" can be mounted on vehicles such as a hybrid electric vehicle (HEV), a plug-in hybrid electric vehicle (PHEV), and a battery electric vehicle (BEV). It should be noted that the use of the "battery cell" is not limited to the use in a vehicle.

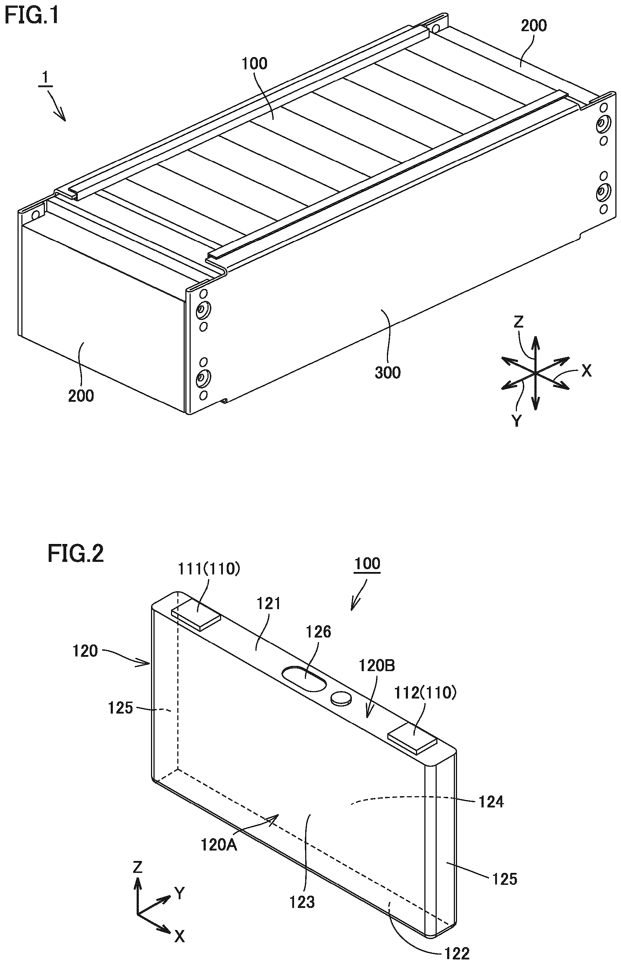

Fig. 1 is a diagram showing a basic configuration of a battery assembly 1. As shown in Fig. 1, battery assembly 1 includes battery cells 100, end plates 200, and a restraint member 300.

The plurality of battery cells 100 are provided side by side in a Y axis direction (first direction). Thus, a stack of battery cells 100 is formed. Each of battery cells 100 includes electrode terminals 110. A separator (not shown) is interposed between the plurality of battery cells 100. The plurality of battery cells 100, which are sandwiched between two end plates 200, are pressed by end plates 200, and are therefore restrained between two end plates 200.

End plates 200 are disposed on both ends of battery assembly 1 in the Y axis direction. Each of end plates 200 is fixed to a base such as a case that accommodates battery assembly 1. Restraint member 300 connects two end plates 200 to each other.

Restraint member 300 is fixed to end plates 200 with a compression force in the Y axis direction being exerted to the stack of the plurality of battery cells 100 and end plates 200, and then the compression force is released, with the result that tensile force acts on restraint member 300 that connects two end plates 200 to each other. As a reaction thereto, restraint member 300 presses two end plates 200 in directions of bringing them closer to each other.

Fig. 2 is a perspective view showing a battery cell 100. As shown in Fig. 2, battery cell 100 has a prismatic shape. Battery cell 100 has electrode terminals 110, and a housing 120 (exterior container). That is, battery cell 100 is a prismatic secondary battery cell.

Electrode terminals 110 are formed on housing 120. Electrode terminals 110 have a positive electrode terminal 111 and a negative electrode terminal 112 arranged side by side along an X axis direction (second direction) orthogonal to the Y axis direction (first direction). Positive electrode terminal 111 and negative electrode terminal 112 are provided to be separated from each other in the X axis direction.

Housing 120 has a rectangular parallelepiped shape and forms an external appearance of battery cell 100. Housing 120 includes: a case main body 120A that accommodates an electrode assembly (not shown) and an electrolyte solution (not shown); and a sealing plate 120B that seals an opening of case main body 120A. Sealing plate 120B is joined to case main body 120A by welding.

Housing 120 has an upper surface 121, a lower surface 122, a first side surface 123, a second side surface 124, and two third side surfaces 125. Housing 120 is provided with a gas-discharge valve 126.

Upper surface 121 is a flat surface orthogonal to a Z axis direction (third direction) orthogonal to the Y axis direction and the X axis direction. Electrode terminals 110 are disposed on upper surface 121. Lower surface 122 faces upper surface 121 along the Z axis direction.

Each of first side surface 123 and second side surface 124 is constituted of a flat surface orthogonal to the Y axis direction. Each of first side surface 123 and second side surface 124 has the largest area among the areas of the plurality of side surfaces of housing 120. Each of first side surface 123 and second side surface 124 has a rectangular shape when viewed in the Y axis direction. Each of first side surface 123 and second side surface 124 has a rectangular shape in which the X axis direction corresponds to the long-side direction and the Z axis direction corresponds to the short-side direction when viewed in the Y axis direction.

The plurality of battery cells 100 are stacked such that first side surfaces 123 of battery cells 100, 100 adjacent to each other in the Y direction face each other and second side surfaces 124 of battery cells 100, 100 adjacent to each other in the Y axis direction face each other. Thus, positive electrode terminals 111 and negative electrode terminals 112 are alternately arranged in the Y axis direction in which the plurality of battery cells 100 are stacked.

Gas-discharge valve 126 is provided in upper surface 121. When the temperature of battery cell 100 is increased (thermal runaway) and internal pressure of housing 120 becomes more than or equal to a predetermined value due to gas generated inside housing 120, gas-discharge valve 126 discharges the gas to outside of housing 120.

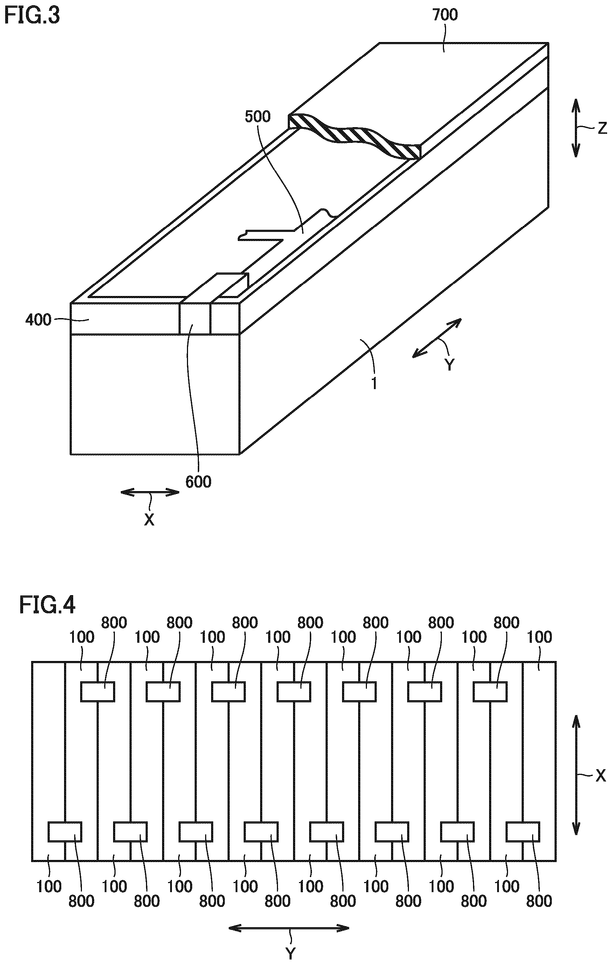

Fig. 3 is a perspective view showing a state in which a wiring module is provided on battery assembly 1. As shown in Fig. 3, a plate member 400 is placed on battery assembly 1, and a flexible printed board 500 is provided on plate member 400. Flexible printed board 500 can be electrically connected to an external device via a connector 600. A cover member 700 is provided on plate member 400 so as to cover flexible printed board 500.

Fig. 4 is a diagram showing an arrangement of bus bars 800 in battery assembly 1. In the example of Fig. 4, positive electrode terminal 111 and negative electrode terminal 112 of adjacent battery cells 100 are electrically connected by bus bar 800, and the plurality of battery cells 100 are electrically connected in series.

That is, battery assembly 1 includes: the plurality of battery cells 100 each having electrode terminals 110 and arranged along a predetermined direction; and bus bars 800 that connect electrode terminals 110 of the plurality of battery cells 100 together.

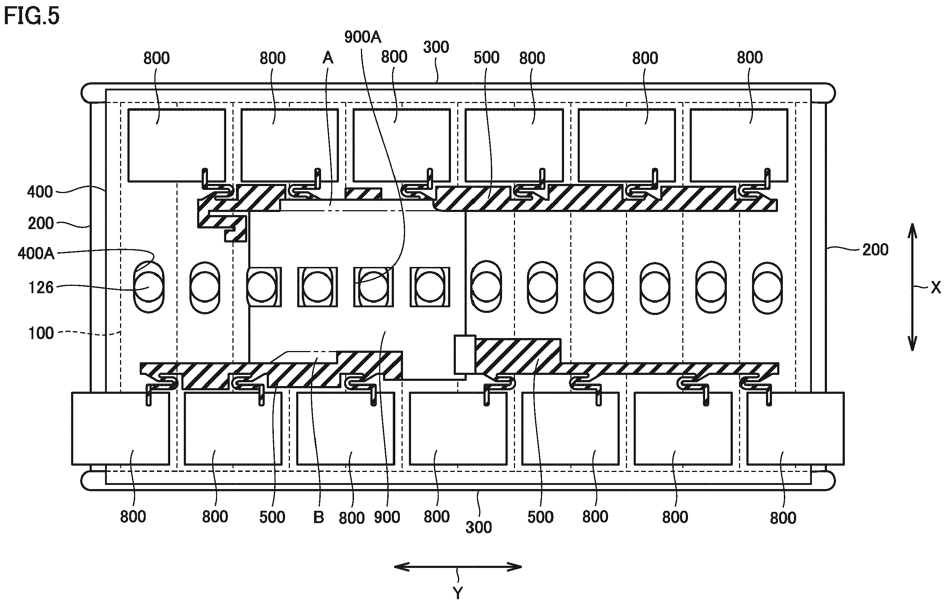

Fig. 5 is a top view of the battery module. As shown in Fig. 5, the battery module includes a control board 900. In the example of Fig. 5, a portion of flexible printed board 500 (each of portions A and B in Fig. 5) is located below control board 900. In other words, a portion of flexible printed board 500 is located between control board 900 and battery cell 100 (between control board 900 and plate member 400 in the example of Fig. 5) at a region overlapping with control board 900 when viewed from the upper side (first side) of the battery module in the Z axis direction. Plate member 400 and control board 900 are respectively provided with openings 400A, 900A above gas-discharge valve 126 of battery cell 100. Therefore, gas-discharge valve 126 is suppressed from being blocked by plate member 400 and control board 900.

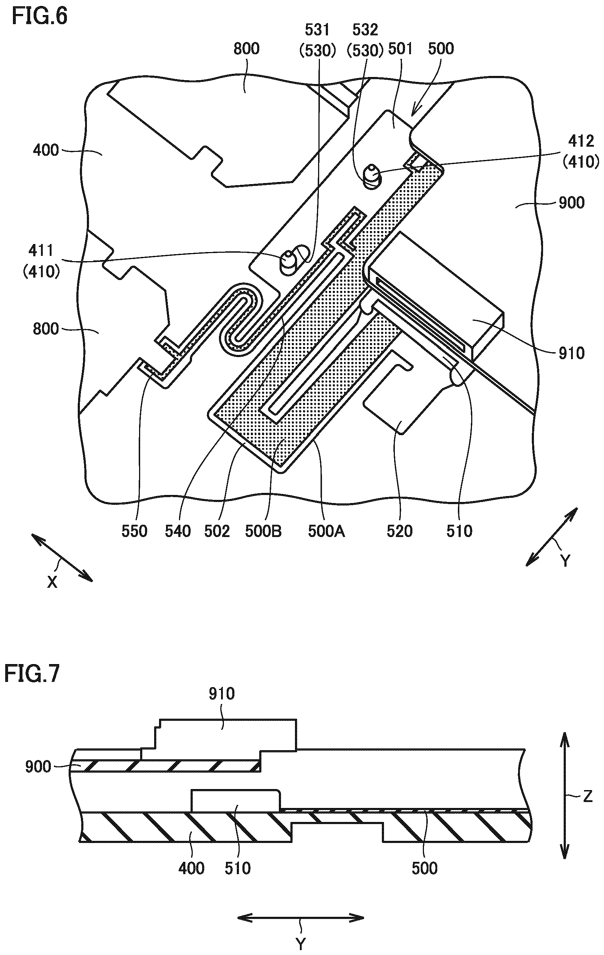

Fig. 6 is a perspective view showing flexible printed board 500 and control board 900 shown in Fig. 5. It should be noted that flexible printed board 500 and control board 900 shown in Figs. 5 and 6 are merely examples, and the scope of the present technology is not limited thereto.

As shown in Fig. 6, flexible printed board 500 has a connection portion 510 and a tab 520. Control board 900 has a connector portion 910. When connection portion 510 of flexible printed board 500 is connected to connector portion 910 of control board 900, flexible printed board 500 and control board 900 are electrically connected to each other. On this occasion, deflection occurs in flexible printed board 500.

In the example of Fig. 6, flexible printed board 500 includes a main body portion 501 (first portion) and a branch portion 502 (second portion) that branches from main body portion 501. In the example of Fig. 6, connection portion 510 is provided at the tip of branch portion 502. Connection portion 510 provided at branch portion 502 is connected to control board 900 in the extending direction (Y axis direction in the example of Fig. 6) of main body portion 501. On this occasion, branch portion 502 adjacent to connection portion 510 is deflected and deformed.

Flexible printed board 500 is constituted of a film layer 500A and a conductor portion 500B formed on film layer 500A. Film layer 500A is composed of an insulating material. Conductor portion 500B is composed of a metal (conductive material) such as copper, for example. Conductor portion 500B forms a wiring such as a voltage detection line or a temperature detection line, for example.

Conductor portion 500B is also formed at each of portions (portions A and B in Fig. 5) located below control board 900. That is, a portion of conductor portion 500B (each of portions A and B in Fig. 5) is located below control board 900. In other words, a portion of conductor portion 500B is located between control board 900 and battery cell 100 (between control board 900 and plate member 400 in the example of Fig. 6) at the region overlapping with control board 900 when viewed from the upper side (first side) of the battery module in the Z axis direction.

Conductor portion 500B of connection portion 510 may pass through a region not overlapping with control board 900 from the region overlapping with control board 900, and may extend to the region overlapping with control board 900 again. For example, in the vicinity of connection portion 510, flexible printed board 500 including conductor portion 500B can be located below control board 900 (at the region overlapping with control board 900) (the first portion of conductor portion 500B), at the portion contiguous to the first portion, flexible printed board 500 including conductor portion 500B can be located at the region exposed from control board 900 (the region not overlapping with control board 900) (the second portion of conductor portion 500B) when viewed from the Z axis direction, and at the portion contiguous to the second portion, flexible printed board 500 including conductor portion 500B can be located below control board 900 (at the region overlapping with control board 900) (the third portion of conductor portion 500B).

In the example of Fig. 6, plate member 400 has a protruding portion 410. Protruding portion 410 includes a first protruding portion 411 and a second protruding portion 412. Flexible printed board 500 is provided with a hole portion 530, a cut-in portion 540, and a bus bar connection portion 550. Hole portion 530 includes an elongated hole 531 and a round hole 532.

First protruding portion 411 of plate member 400 extends through elongated hole 531 of flexible printed board 500, and second protruding portion 412 extends through round hole 532. Elongated hole 531 is formed to have its long-side direction corresponding to the Y axis direction. With elongated hole 531, flexible printed board 500 can be positioned on plate member 400 while absorbing a dimensional tolerance from elongated hole 531 to round hole 532 in the Y axis direction and an assembly tolerance between plate member 400 and flexible printed board 500.

Cut-in portion 540 is provided between main body portion 501 and branch portion 502 of flexible printed board 500. Cut-in portion 540 is formed along the extending direction (Y axis direction in the example of Fig. 6) of main body portion 501. Bus bar connection portion 550 is a portion of conductor portion 500B, and is provided at the tip of main body portion 501. Bus bar connection portion 550 is connected to bus bar 800.

In the example of Figs. 5 and 6, battery cell 100, plate member 400, flexible printed board 500, and control board 900 overlap with one another in this order at least at a certain region when viewed in the Z axis direction, but the scope of the present technology is not limited thereto. For example, when plate member 400 is provided with an opening at the certain region, battery cell 100, flexible printed board 500, and control board 900 overlap with one another in this order along the Z axis direction.

Fig. 7 is a diagram showing an exemplary positional relation between connection portion 510 of flexible printed board 500 and connector portion 910 of control board 900.

As shown in Fig. 7, in a state in which connection portion 510 is not connected to connector portion 910, i.e., in a state in which no deflection is formed in flexible printed board 500, a portion of connection portion 510 of flexible printed board 500 is located below control board 900. In other words, a portion of connection portion 510 is located between control board 900 and plate member 400 at the region overlapping with control board 900 when viewed from the upper side (first side) of the battery module in the Z axis direction. It should be noted that the whole of connection portion 510 of flexible printed board 500 may be located below control board 900.

Tab 520 shown in Fig. 6 is provided in the vicinity of connection portion 510 and protrudes from the region overlapping with control board 900. By pulling tab 520 in the Y axis direction, connection portion 510 can be pulled out from below control board 900.

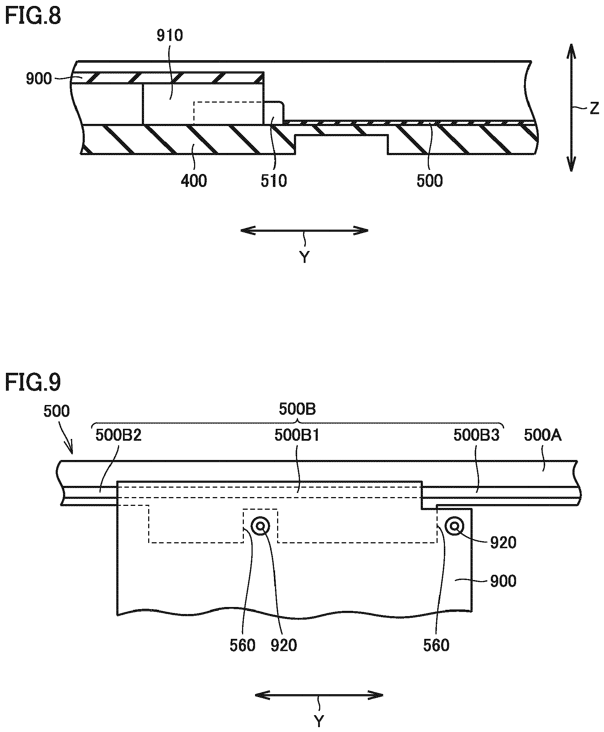

Fig. 8 is a diagram showing a modification of the positional relation between connection portion 510 of flexible printed board 500 and connector portion 910 of control board 900.

In the example shown in Fig. 8, connector portion 910 is located below control board 900. In other words, connector portion 910 is located between control board 900 and plate member 400 at the region overlapping with control board 900 when viewed from the upper side (first side) of the battery module in the Z axis direction. As a further modification, only a portion of connector portion 910 may be located below control board 900.

By disposing at least a portion of connector portion 910 below control board 900 in this way, the height of the battery module can be made small.

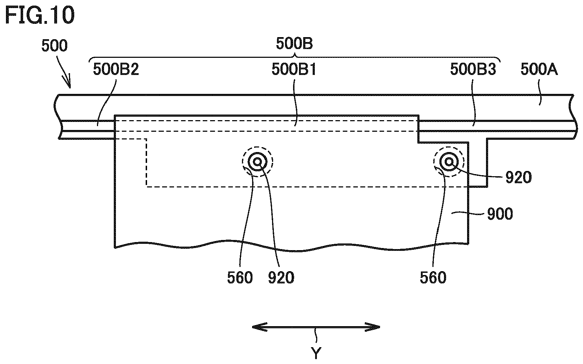

Each of Figs. 9 and 10 is a top view showing a shape of a flexible printed board 500 according to a modification.

In the modification shown in each of Figs. 9 and 10, control board 900 has a fastening portion 920 for plate member 400. Flexible printed board 500 reaches the deep side of control board 900 with respect to fastening portion 920. Flexible printed board 500 has an avoidance portion 560 that avoids fastening portion 920. Thus, the region (area) of flexible printed board 500 can be increased while avoiding interference with fastening portion 920.

Avoidance portion 560 may be constituted of a recess as in the example of Fig. 9, or may be constituted of a hole as in the example of Fig. 10.

According to the present embodiment, since at least a portion of conductor portion 500B (wiring) of flexible printed board 500 is disposed at the position overlapping with control board 900 when viewed in the Z axis direction, a limited space on the battery module can be efficiently utilized, with the result that a large number of conductor portions 500B can be disposed thereon.

Although the embodiments of the present invention have been described and illustrated in detail, it is clearly understood that the same is by way of illustration and example only and is not to be taken by way of limitation, the scope of the present invention being interpreted by the terms of the appended claims. The scope of the present invention is defined by the terms of the claims, and is intended to include any modifications within the scope and meaning equivalent to the terms of the claims.

## Claims

1. A battery module comprising:
a plurality of battery cells (100) arranged in a first direction;
a plate member (400) provided on a first side of the plurality of battery cells (100); and
a flexible printed board (500) and a control board (900) each provided on the plate member (400), wherein
the flexible printed board (500) has a wiring (500B) electrically connected to the control board (900), and
at least a portion of the wiring (500B) of the flexible printed board (500) is located between the control board (900) and at least one of the battery cells (100) at a region overlapping with the control board (900) when viewed from the first side.

2. The battery module according to claim 1, wherein at least the portion of the wiring (500B) of the flexible printed board (500) is located between the control board (900) and the plate member (400) at the region overlapping with the control board (900) when viewed from the first side.

3. The battery module according to claim 1 or 2, wherein the plate member (400) has a protruding portion (410) that positions the flexible printed board (500).

4. The battery module according to any one of claims 1 to 3, wherein
the control board (900) has a connector portion (910), and
the flexible printed board (500) has a connection portion (510), and the flexible printed board (500) and the control board (900) are electrically connected to each other when the connection portion (510) is connected to the connector portion (910).

5. The battery module according to claim 4, wherein at least a portion of the connector portion (910) or the connection portion (510) is located between the control board (900) and the at least one of the battery cells (100) at the region overlapping with the control board (900) when viewed from the first side.

6. The battery module according to any one of claims 1 to 5, wherein the flexible printed board (500) has a film layer (500A) and a conductor portion (500B) formed on the film layer (500A) and forming the wiring (500B).

7. The battery module according to any one of claims 1 to 6, wherein
the wiring (500B) includes
a first portion that is located at the region overlapping with the control board (900) when viewed from the first side,
a second portion that is contiguous to the first portion (501) and that is located at a region exposed from the control board (900) when viewed from the first side, and
a third portion that is contiguous to the second portion on a side opposite to the first portion and that is located at the region overlapping with the control board (900) when viewed from the first side.

8. The battery module according to any one of claims 1 to 7, wherein the wiring (500B) includes one of a voltage detection line or a temperature detection line.

9. The battery module according to any one of claims 1 to 8, wherein the control board (900) has a fastening portion (920) with which the flexible printed board (500) is fastened.

10. The battery module according to claim 9, wherein the flexible printed board (500) has an avoidance portion (560) that avoids the fastening portion (920).
